# EUROPEAN PATENT SPECIFICATION

(11) **EP 1 904 665 B1**
(45) Date of publication and mention of the grant of the patent: **25.02.2009**
(21) Application number: 06800040.5
(22) Date of filing: 11.07.2006
(51) Int. Cl.: C23C 16/458, C23C 16/04

(54) **IMPROVED SUPPORT STRUCTURE FOR RADIATIVE HEAT TRANSFER**
VERBESSERTE STÜTZSTRUKTUR ZUR RADIATIVEN WÄRMEÜBERTRAGUNG
STRUCTURE SUPPORT AMELIOREE DESTINEE AU TRANSFERT DE CHALEUR PAR RAYONNEMENT

(30) Priority: 14.07.2005 US 698924 P; 06.07.2006 US 480863
(43) Date of publication of application: 02.04.2008
(73) Proprietor: Honeywell International Inc., Morristown NJ 07960 (US)
(72) Inventor: ARICO, Alan, A., South Bend, IN 46614 (US); WAGHRAY, Akshay, Granger, IN 46530 (US); PARKER, David, E., Granger, IN 46530 (US)
(74) Representative: Buckley, Guy Julian
(86) International application number: PCT/US2006/026890
(87) International publication number: WO 2007/011581

(56) References cited:
- EP-A1- 0 846 787
- WO-A-20/04072322
- US-A- 5 904 957

## Description

### FIELD OF THE INVENTION

This invention concerns the manufacture of annular carbon-carbon composite preforms, and more specifically, chemical vapor infiltration and deposition (CVI/CVD) processes used in their manufacture. This invention provides an improved apparatus which can be used to carry out highly uniform CVI/CVD processes without occasioning damage such as warping or indentation in carbon-carbon composite preforms being densified by such processes.

### BACKGROUND OF THE INVENTION

Carbon-carbon composite preforms are employed to produce, for instance, brake discs. Carbon-carbon composite preforms are made by densifying a fibrous substrate that has the approximate shape of the preform to be manufactured. This densification process typically includes multiple cycles of Chemical Vapor Infiltration (CVI) and/or Chemical Vapor Deposition (CVD). CVI/CVD cycles are an important cost factor in the manufacture of carbon-carbon composite preforms.

Chemical vapor infiltration and deposition are well known techniques for depositing binding matrix within porous structures. The terminology "chemical vapor deposition (CVD) generally implies deposition of a surface coating, but the terminology is also used to refer to infiltration and deposition of a matrix *within* a porous structure. As used herein, the terminology "CVI/CVD" refers to infiltration and deposition of a matrix within a porous structure. These techniques are suitable for fabricating high temperature structural composites by depositing a carbonaceous matrix within a carbonaceous porous structure composed of fibers. In this application, the terminologies "chemical vapor infiltration" and "chemical vapor deposition" and the acronyms CVI, CVD, and CVI/CVD are often used interchangeably.

Densifying porous substrates by chemical vapor infiltration consists in placing the substrates in a reaction chamber of an infiltration installation by means of support tooling, and admitting into the chamber a gas having one or more components constituted by precursors for the material that is to be deposited within the substrates for the purpose of densifying them. Infiltration conditions, in particular gas composition and flow rate and temperature and pressure inside the chamber, are selected to enable the gas to diffuse within the accessible internal pores of the substrates so that the desired material is deposited therein by a component of the gas decomposing or by a reaction between a plurality of the component thereof. For instance, CVI of pyrolytic carbon generally makes use of a precursor such as an alkane, e.g., propane, methane, or mixtures thereof.

In industrial installations for chemical vapor infiltrations, it is usual to load the reaction chamber with a plurality of substrates or preforms to be densified simultaneously, by using support tooling comprising, in particular, trays and spacers. When the preforms are annular, they may be stacked vertically in the reaction chamber.

Generally speaking, manufacturing carbon parts using a CVI/CVD process involves placing preformed porous structures in a furnace and introducing a high temperature reactant gas to the porous structures. When carbon-carbon aircraft brake discs are being manufactured, fibrous carbon porous structures typically are treated with a reactant gas mixture of natural gas, which may be enriched with propane gas. When the hydrocarbon gas mixture flows around and through the porous structures, a complex set of dehydrogenation, condensation, and polymerization reactions occur, thereby depositing the carbon atoms within the interior and onto the surface of the porous structures. Over time, as more and more of the carbon atoms are deposited onto the structures, the porous structures become more dense. This process is sometimes referred to as densification, because the open spaces in the porous structures are eventually filled with a carbon matrix until generally solid carbon parts are formed.

US 5,904,957 discloses one approach to CVI tooling. In US 5,904,957, spacers (3, 33, 51, 71) appear to be individual components located in widely separated positions between preforms above and below them. US 6,669,988 B2 likewise discloses spacers (6) that appear to be individual components located in widely separation positions between preforms above and below them. US 6,669,988 B2 also discloses, in its Figure 11, described in the paragraph bridging columns 9-10 of the patent, spacer rings (138) that are designed to seal off open passages at the outside edges of the annular preforms being densified, forcing reactant gas to flow through the interior regions of the brake discs.

Control variables in chemical vapor infiltration and deposition processes include: preform temperature and pore structure; reactant gas composition, flow rate, temperature, and pressure; and reaction time. The surface reaction of deposition of carbon is an exponential function of the preform temperature. The process therefore is very sensitive to this parameter. Maintaining a controlled uniform temperature throughout the furnace in which preforms are being treated is important to achievement of consistent densification results. Based upon these critical control variables, CVI/CVD processes may be broadly classified as: Conventional - isothermal and isobaric; Thermal gradient (for example, US 5,348,774); and Pressure gradient or forced flow (for example, US 5,480,678).

In conventional processing, the intent is to maintain all of the brake discs at a constant temperature during the process ("isothermal"). This is not, however, successfully achieved in many applications. For instance, the heat source is from the outer diameter of the cylindrical vessel in all of the depictions of the process in US 5,904,957 and US 6,669,988 B2. In such embodiments of the so-called isothermal process, the heat transfer to the stacks located in the center of the furnace is not the same as is the heat transfer to the stacks located near the walls. This results in the center stacks not densifying to the same extent as do the stacks near the walls, which results in the need for additional correction cycles and/or in a potential for undesired microstuctures impacting cost and perhaps variability in friction performance of the brakes.

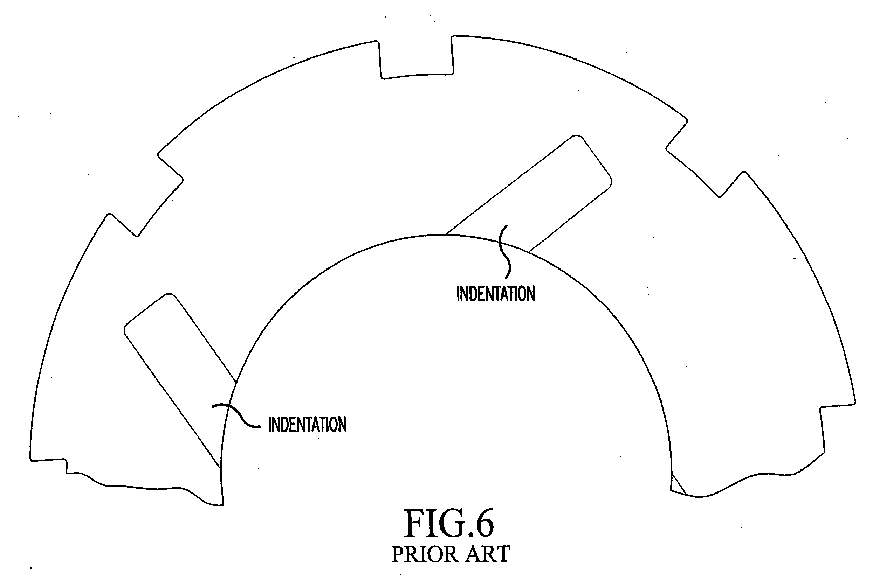

Larger sized preforms - such as those designed to be used in the manufacture of brake discs for big jetliners - often require 3, 4, or even more cycles of CVD to meet minimum density requirements. Preforms are arranged, usually on top of a baffle plate, in stacks so that they can be subjected to CVD processing. Normally, the individual preforms in each stack are separated by spacers. Particularly with larger sized preforms, prior to the first CVD cycle, the individual preforms ("green" preforms) at the bottom of the stacks may warp due to the weight of the other preforms above them or may be indented by the spacers. Indentations are visible in Figure 6. Such indentations occur during the first cycle of CVI/CVD processing, when the "green" nonwoven preforms are still flexible and the number of green discs per stack is over 15.

### SUMMARY OF THE INVENTION

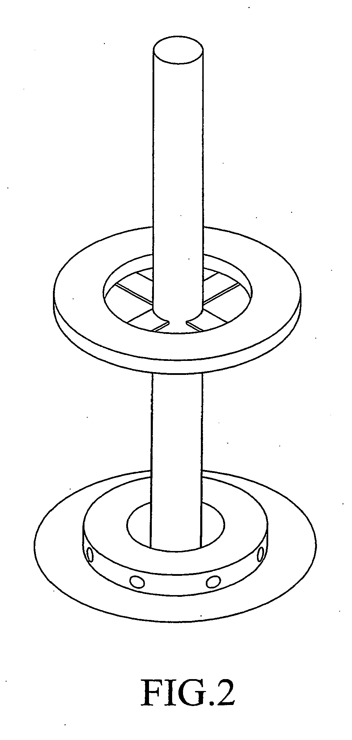

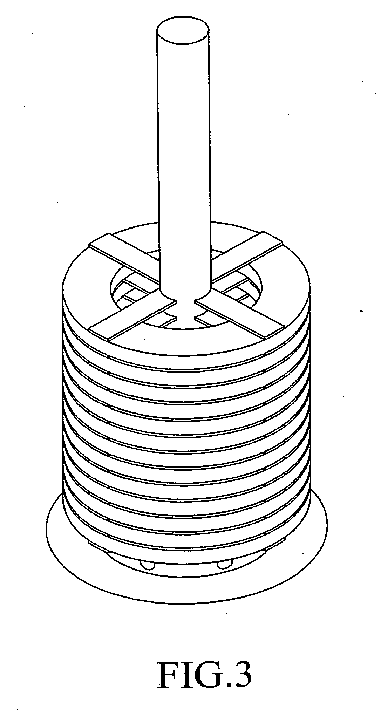

This invention provides a solution which reduces indentation and warpage problems. In accordance with this aspect of the present invention, the central structural member is provided with tabs or shelves to support each preform and to separate each preform from those above and below it. These tabs or shelves may be made of graphite or of carbon-carbon composite material. While those skilled in the art will readily conceive of many different ways in which the tabs or shelves could be provided on the central structural member, one convenient means is to employ holes punched in the central structural member. Figure 2 illustrates a central structural member in accordance with the present invention, bearing 4 tabs which serve as a shelf for a single preform. In practice, of course, the central structural member would normally be provided with sufficient tabs/shelves to support multiple preforms. Figure 3 illustrates a stack of preforms supported on shelves in accordance with the present invention.

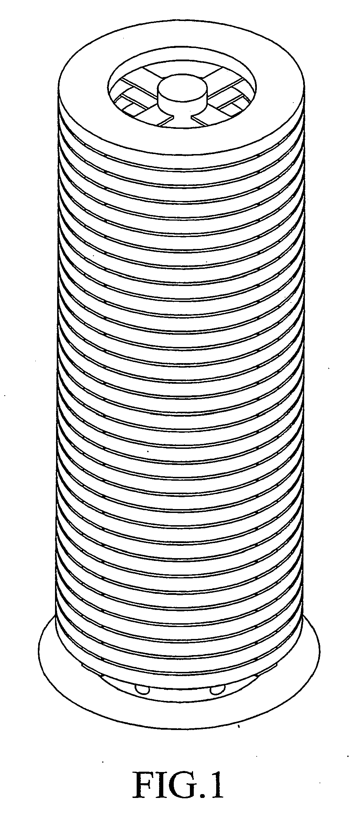

The present invention also provides a solution which ameliorates the necessity for multiple CVD cycles to meet minimum density requirements with large annular preforms. This solution involves positioning a structural member inside of the cylinder described by the inside diameters of the stacked preforms. This aspect of the present invention is illustrated in Figure 1. The structural member that is positioned inside the stacked preforms in accordance with the present invention is selected to provide a "black body" or radiative substrate for absorption of heat. The passive heat distribution element is composed either of a thick graphite shaft or of a thick previously densified carbon-carbon shaft. This passive heat distribution element may be solid, or it may be a hollow cylinder, filled, for instance, with annular graphite rings or with previously densified C-C filler discs arranged with no spacers between them. The heat absorbed by this central structural member is in turn radiated to the preforms through their inside diameters. The transmission of heat from the central structural member speeds up chemical reactions occurring in the gases within the carbon-carbon composite preforms, thus making each CVD cycle more efficient, and reducing the total number of cycles necessary to raise the density of the preforms to a given target level. In accordance with the present invention, the central structural member may be made of graphite or of carbon-carbon composite material.

During the densification process, the passive heat distribution element absorbs a large portion of the heat in the furnace and radiatively and uniformly distributes the heat to the surrounding stack of preforms. The gaps between the walls of the apparatus and the preform discs are preferably kept small, so that the reactant gas flows uniformly around the preform discs being densified, and is forced through the preforms. This invention provides greater and more uniform weight pickup throughout the stacks. That is, in accordance with this invention, all of the preforms in a given densification batch are more uniform in density than are the preforms in a comparable batch made by a process that has no heat distribution element in the center of the furnace muffle. This uniformity results in a higher overall average density for the batch of preforms.

### BRIEF DESCRIPTION OF THE DRAWINGS

The present invention will become more fully understood from the detailed description given hereinbelow, and from the drawings that accompany this application. These drawings are provided by way of illustration only and should not be construed as limiting the invention.

Figure 1 is a perspective view showing a combination spacer "tree" and heat distribution element positioned inside of a cylinder described by the inside diameters of the stacked large preforms in accordance with the present invention.

Figure 2 is a perspective view illustrating a central structural member in accordance with the present invention bearing 4 tabs which serve as a shelf for a single preform.

Figure 3 is a perspective view illustrating a stack of preforms supported on shelves in accordance with the present invention.

Figure 4 is a top plan view of an apparatus of the present invention.

Figure 5 is a perspective view showing heat distribution "jackets" that may be used in accordance with the present invention.

Figure 6 is a photograph showing indentations imparted to a brake disc preform that was densified in an apparatus other than that of the present invention.

### DETAILED DESCRIPTION OF THE INVENTION

One embodiment of the present invention is a method for densifying a porous carbon preform. The method includes the steps of: providing an apparatus charged with at least one stack of annular porous carbon-carbon composite preforms, the preforms being separated from one another by spacers emanating from a passive heat distribution element centrally located within a cylindrical space formed by the stack of annular preforms; locating the charged apparatus in a furnace at a temperature in the range of 950-1 100°C and a pressure in the range of 665-5330 Pa (5-40 torr); and circulating a carbon-containing gas reactant through the apparatus for from 150 to 900 hours. In accordance with the present invention, the preforms are densified with less than 1 % total physical damage due to the weight of the preforms being treated than are a batch of preforms made by an otherwise identical process that does not separate preforms from the preforms immediately above and below them by spacer elements comprising tabs or shelves emanating from a central passive heat distribution structural member.

Another embodiment of the present invention is an apparatus. The apparatus is a furnace muffle for use in a CVI/CVD furnace that comprises a bottom, a top, and an outer wall defining an interior space in the apparatus, the furnace muffle having at least one stack of at least 20 (e.g., from 25 to 40) carbon-carbon composite preforms located within its interior space.
In accordance with this invention, each preform is separated from the preforms immediately above and below it by spacer elements comprising tabs or shelves emanating from a central passive heat distribution structural member located within the interior space. The apparatus of this invention may further include a large carbon-carbon composite or graphite tube around the outside of each stack of preforms, thereby forming a heat-transfer enhancing "jacket" to increase the efficiency of the CVI/CVD cycle. The central structural member, the tabs/shelves, and/or the jacket may be made of graphite or of carbon-carbon composite material.

In one embodiment of the apparatus embodiment of this invention, each central passive heat distribution member may be made of graphite or carbon-carbon composite. When made of graphite, these central passive heat distribution members are preferably end-capped graphite tubes 12.5-20.5 cm (5-8) inches) in diameter or are cylindrical rods 2.5-12.5 cm (1 -5 inches) in diameter. When made of carbon-carbon composite material, these central passive heat distribution members are preferably end-capped carbon-carbon composite tubes 12.5-20.5 cm (5-8 inches) in diameter. Typically, although not necessarily, each passive heat distribution element may have a mass in the range of 100-300 kilograms. Typically, the bottom and top of the furnace muffle are planar and the outer wall and the central passive heat distribution member are cylindrical in shape, with the bottom, top, and outer walls being composed of graphite or carbon-carbon composite material.

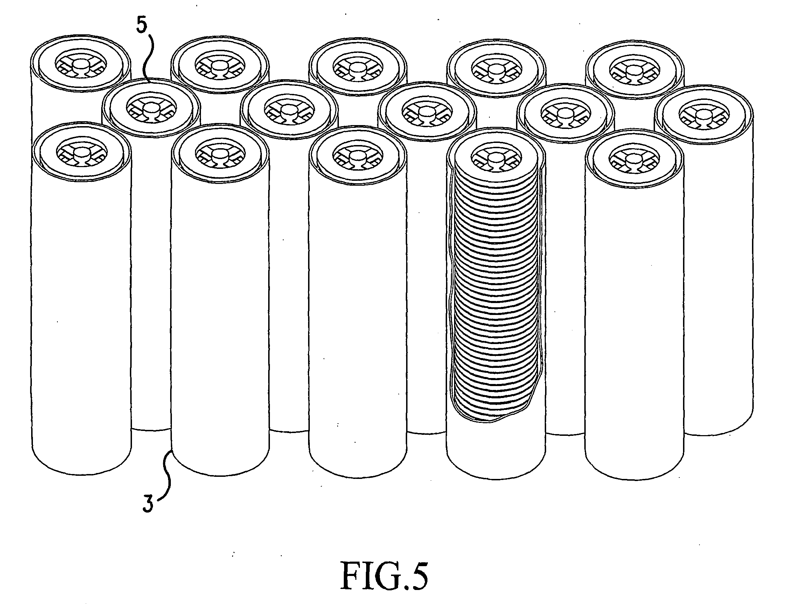

The present invention may be used in the conventional process, which is designed to maintain the preform temperature at a constant (isothermal) with no significant pressure differentials in the furnace (isobaric). In conventional densification, annular brake discs are arranged in stacks with adjacent brake discs stacked on top of one another. A center opening region is thus formed through the center of each stack. Figure 2 of US 6,669,988 B2 shows on the order of a dozen stacks located together in a densification furnace. As may be seen e.g. in Figure 5 of US 6,953,605 B2, each stack may contain on the order of two score brake disc preforms. Graphite or carbon-carbon spacers are placed between adjacent brake discs to form open passages between the center opening region and the outer region. The reactant gas flows randomly around the stack and may flow through the open passages from the center opening region to the outer opening region or vice versa, with no significant pressure gradients. The stacks may optionally be confined within graphite or carbon-carbon cylindrical structures. Conventional densification treatments are generally conducted for several hundreds of hours.

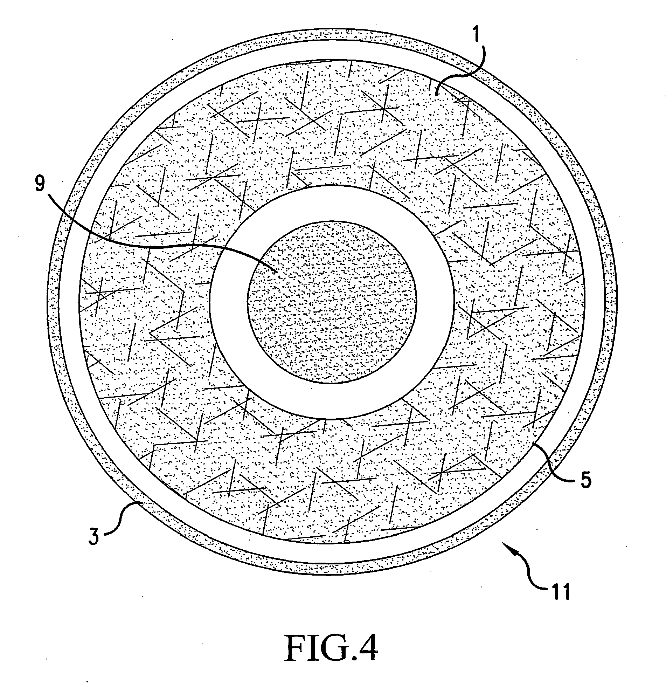

In the embodiment of the present invention illustrated in Figure 4, the central structural member 9 is positioned inside the cylinder described by the inside diameter of the stacked preforms, either before or after the preforms are stacked. As shown in Figure 4, a "black body" or radiative substrate for absorption of heat (e.g., a large carbon-carbon composite or graphite tube), identified by reference numeral 3. may be placed around the stack of preforms on the outside to form a heat-transfer enhancing "jacket" to increase the efficiency of a given CVD cycle still further.

The present apparatus. In more detail, this invention provides an apparatus for use in a CV1/CVD furnace. The apparatus of this invention may be a furnace muffle. The apparatus has a bottom, a top, and an outer wall defining an interior space in the apparatus, and a passive heat distribution element located within the interior and apart from the outer wall. The outer wall of the apparatus may conveniently be cylindrical in shape and the top and bottom of the apparatus may conveniently be planar. Generally the passive heat distribution element will be located in the center of the interior space. The passive heat distribution element may conveniently be cylindrical in shape. In accordance with this invention, the passive heat distribution element will have a mass in the range of 100-300 kilograms.

In the apparatus of this invention, the bottom, top, and outer walls will generally comprise graphite or carbon-carbon composite material. Without limitation, in specific embodiments of the present invention, the outer wall of the furnace muffle may be 2.5 cm (1 inch) thick and 145 cm (57 inches) in internal diameter. Typically, the bottom and top walls will be perforated, in order to facilitate the passage of gases involved in the densification process. Like the walls, the passive heat distribution element will also, independently, comprise graphite or carbon-carbon composite. The passive heat distribution element may be constituted of carbon-carbon composite material which forms a cylindrical member located within the furnace muffle. See Figure 4. Those skilled in the art will readily conceive of many different sizes and many different ways in which to provide a passive heat distribution element in accordance with the principles of this invention.

In use, the apparatus of this invention will have located therein at least one stack of annular porous carbon preforms, preferably configured as aircraft landing system brake discs. Each stack may contain on the order of two score brake disc preforms, although shorter or taller stacks may be treated in the present invention. In accordance with the present invention, the preforms charged into the furnace muffle for densification will be separated from one another by spacers projecting from the central heat distribution element.

This invention provides highly uniform batches of carbon-carbon composite preforms. In accordance with the present invention, the density of a batch of preforms prepared by the method of this invention is generally at least 0.5 g/cc higher than the density of a batch of preforms made by an otherwise identical process in which the apparatus employed for densification does not contain a passive heat distribution element as described herein located within its interior.

As depicted in the top plan view of Figure 4, the apparatus 11 of this invention may comprise a space 1 defined by an outer wall 3 and a positive heat distribution element 9. Located within the space is a stack of preforms 5. The passive heat distribution element contemplated by the present invention may be a solid core or may be a tube with end caps. Inner and outer components 3 and 9 can be made of any suitable material, such as graphite or carbon-carbon composite. The passive heat distribution element can be made of any material that will provide the apparatus with an inner source of heat at a level comparable to the heat being provided to the whole apparatus by the furnace. An especially convenient passive heat distribution element material is carbon-carbon composite material. Both the bottom and the top of apparatus 1 1 may be closed by perforated plates made of a suitable material such as graphite or carbon-carbon composite. The perforated plates permit the entrance of carbon- containing gas into space 1, as well as the exit of waste gases, during CVI/CVD processing.

Figure 5 is a perspective view of multiple stacks of preforms 5, showing a heat distribution element 3 encircling each stack of preforms. This invention is particularly useful for densifying larger annular discs - those having outside diameters in the range 40.5-56 cm (16 inches to 22 inches). Such larger discs are typically densified in a configuration such as that illustrated in Figure 5.

Densification. The apparatus of this invention is especially useful for carbon densification of annular carbon-carbon composite preforms to be used for high performance brake discs. The apparatus supports and positions a number of brake discs which are stacked on top of each other in stacks. During the densification process, the apparatus and stacks of discs are enclosed in a furnace. Hot hydrocarbon gases are caused to flow around and through the stacks of brake discs, thereby depositing a carbon matrix within the interior regions and on the surface of the porous brake disc structures. The absolute gas pressure for the furnace is typically about 665-5330 Pa (5-40 torr), the temperature range is typically about 950-1 100°C, and the densification time is typically from 150 to 900 hours. A variety of different types of gas may be used. One may use for instance 100% natural gas. Alternatively to the use of natural gas alone, one may use a blend of natural gas with up to about 15% propane.

Among the types of furnaces that may be used for CVI/CVD processing in accordance with the present invention is an induction furnace or a resistively heated furnace that includes tubular furnace walls enclosing the apparatus of this invention.
This furnace would also have inlet ducts and outlet ducts for introducing and exhausting the gas mixture into and out of the furnace. A preheater may also be provided within the furnace to heat the gas before the gas is directed to the porous preforms. Typically, the preheater is sealed and the incoming gas from the inlet ducts is received by the preheater before being introduced into the apparatus ofthis invention. The preheated gas is then discharged from the preheater through discharge openings in the furnace floor plate of the preheater. Full details of such a furnace assembly may be found in US 6,669,988 B2.

The present invention has been described herein in terms of several embodiments. Additions and modifications to these embodiments will become apparent to those skilled in the relevant arts upon a reading of the foregoing description. All such obvious modifications and additions are intended to be included within the present invention to the extent they fall within the scope of the several claims appended hereto.

## Claims

1. A method for densifying a porous carbon preform, which method comprises the steps of:
providing an apparatus charged with at least one stack of annular porous carbon-carbon composite preforms, said preforms being separated from one another by spacers emanating from a passive heat distribution element centrally located within a cylindrical space formed by the stack of annular preforms;
locating said charged apparatus in a furnace at a temperature in the range of 950- 1100°C and a pressure in the range of 665-5330 Pa (5-40 torr); and
circulating a carbon-containing gas reactant through said apparatus for from 150 to 900 hours,
whereby said preforms are densified with less than 1 % total physical damage due to the weight of the preforms being treated than are a batch of preforms made by an otherwise identical process that does not separate preforms from the preforms immediately above and below them by spacer elements comprising tabs or shelves emanating from a central passive heat distribution structural member.

2. An apparatus comprising a furnace muffle for use in a CVI/CVD furnace that comprises a bottom, a top, and an outer wall defining an interior space in the apparatus, wherein said furnace muffle has at least one stack of at least 20 carbon-carbon composite preforms located within said interior space, each preform being separated from the preforms immediately above and below it by spacer elements comprising tabs or shelves emanating from a central passive heat distribution structural member located within said interior space, wherein the central structural member and the tabs/shelves are made of graphite or of carbon-carbon composite material.

3. The apparatus of claim 2, further comprising a large carbon-carbon composite or graphite tube around the outside of each stack of preforms, thereby forming a heat-transfer enhancing "jacket" to increase the efficiency of the CVI/CVD cycle.

4. The apparatus of claim 2, wherein said central passive heat distribution member is an end-capped graphite tube 12.5-20.5 cm (5-8 inches) in diameter or is a cylindrical rod 2.5-12.5 cm (1 -5 inches) in diameter.

5. The apparatus of claim 2, wherein said central passive heat distribution member is an end-capped carbon-carbon composite tube 12.5-20.5 cm (5-8 inches) in diameter.

6. The apparatus of claim 2, wherein the bottom and top of said furnace muffle are planar and said outer wall and said central passive heat distribution member are cylindrical in shape, and wherein said bottom, top, and outer walls comprise graphite or carbon-carbon composite material.

## Patentansprüche

1. Verfahren zum Verdichten eines porösen Kohlenstoffvorformlings, wobei das Verfahren die folgenden Schritte umfasst:
Bereitstellen einer Vorrichtung, die mit mindestens einem Stapel aus ringförmigen porösen Kohlenstoff-Kohlenstoff-Verbundvorformlingen beladen ist, wobei die Vorformlinge durch Abstandshalter voneinander getrennt sind, die von einem passiven Wärmeverteilungselement ausgehen, das zentral in einem zylindrischen Raum angeordnet ist, der durch den Stapel ringförmiger Vorformlinge gebildet wird;
Anordnen der beladenen Vorrichtung in einem Ofen bei einer Temperatur im Bereich von 950 bis 1100°C und einem Druck im Bereich von 665 bis 5330 Pa (5 bis 40 Torr); und
Zirkulieren eines Kohlenstoff-haltigen Gasreaktanten 150 bis 900 Stunden durch die Vorrichtung,
wobei die Vorformlinge mit weniger als 1% physischer Gesamtschädigung aufgrund des Gewichts der behandelten Vorformlinge verdichtet werden, im Vergleich zu einer Charge von Vorformlingen, die durch einen sonst identischen Prozess hergestellt wird, der die Vorformlinge nicht von den unmittelbar darüber und darunter liegenden Vorformlingen durch Abstandshalterelemente trennt, die Laschen oder Platten umfassen, die von einem zentralen passiven Wärmeverteilungsstrukturelement ausgehen.

2. Vorrichtung, umfassend eine Ofenmuffel zur Verwendung in einem CVI/CVD-Ofen, die einen Boden, eine Oberseite, eine Außenwand, die einen Innenraum in der Vorrichtung definiert, umfasst, wobei die Ofenmuffel mindestens einen Stapel von mindestens 20 Kohlenstoff-Kohlenstoff-Verbundvorformlingen aufweist, die in dem Innenraum angeordnet sind, wobei jeder Vorformling von den unmittelbar darüber und darunter liegenden Vorformlingen durch Abstandshalterelemente getrennt ist, die Laschen oder Platten umfassen, die von einem zentralen passiven Wärmeverteilungsstrukturelement ausgehen, das sich in dem Innenraum befindet, wobei das zentrale Strukturelement und die Laschen/Platten aus Grafit oder aus einem Kohlenstoff-Kohlenstoff-Verbundmaterial bestehen.

3. Vorrichtung nach Anspruch 2, des Weiteren umfassend eine große Kohlenstoff-Kohlenstoff-Verbund- oder Grafitröhre um die Außenseite jedes Stapels an Vorformlingen, wodurch ein die Wärmeübertragung verstärkender "Mantel" zur Erhöhung der Effizienz des CVI/CVD-Zyklus gebildet wird.

4. Vorrichtung nach Anspruch 2, wobei das zentrale passive Wärmeverteilungselement eine Grafitröhre mit Endkappe mit einem Durchmesser von 12,5 bis 20,5 cm (5 bis 8 Inch) oder eine zylindrische Stange mit einem Durchmesser von 2,5 bis 12,5 cm (1 bis 5 Inch) ist.

5. Vorrichtung nach Anspruch 2, wobei das zentrale passive Wärmeverteilungselement eine Kohlenstoff-Kohlenstoff-Verbundröhre mit Endkappe mit einem Durchmesser von 12,5 bis 20,5 cm (5 bis 8 Inch) ist.

6. Vorrichtung nach Anspruch 2, wobei der Boden und die Oberseite der Ofenmuffel eben sind und die Außenwand und das zentrale passive Wärmeverteilungselement eine zylindrische Form aufweisen, und wobei der Boden, die Oberseite und die Außenwände Grafit oder Kohlenstoff-Kohlenstoff-Verbundmaterial umfassen.

## Revendications

1. Procédé pour densifier une préforme de carbone poreuse, ledit procédé comprenant les étapes consistant à:
fournir un appareil chargé avec au moins une pile de préformes composites de carbone - carbones poreuses annulaires, lesdites préformes étant séparées les unes des autres par des écarteurs qui sortent d'un élément de distribution de chaleur passif central qui est situé à l'intérieur d'un espace cylindrique formé par la pile de préformes annulaires;
placer ledit appareil chargé dans un four à une température comprise dans la gamme de 950°C à 1100°C et à une pression comprise dans la gamme de 665 Pa à 5330 Pa (5 à 40 torrs); et
faire circuler un réactif gazeux contenant du carbone à travers ledit appareil pendant de 150 à 900 heures,
dans lequel lesdites préformes sont densifiées avec moins de 1 % d'endommagement physique total à cause du poids des préformes qui sont traitées comparativement à des préformes d'un lot produit par un procédé par ailleurs identique qui ne sépare pas les préformes des préformes qui sont situées immédiatement au-dessus et en dessous de celles-ci à l'aide d'éléments d'écartement comprenant des pattes ou des tablettes qui sortent d'un élément structurel de distribution de chaleur passif central.

2. Appareil comprenant un moufle de four à utiliser dans un four CVI/CVD, comprenant une paroi inférieure, une paroi supérieure et une paroi extérieure qui définissent un espace intérieur dans l'appareil, dans lequel ledit moufle de four comprend au moins une pile d'au moins 20 préformes composites de carbone - carbone situées à l'intérieur dudit espace intérieur, chaque préforme étant séparée des préformes situées immédiatement au-dessus et en dessous d'elle par des éléments d'écartement comprenant des pattes ou des tablettes qui sortent d'un élément structurel de distribution de chaleur passif central qui est situé à l'intérieur dudit espace intérieur, dans lequel l'élément structurel central et les pattes/tablettes sont constituées de graphite ou d'une matière composite de carbone - carbone.

3. Appareil selon la revendication 2, comprenant en outre un grand tube de graphite ou de composite de carbone - carbone autour de l'extérieur de chaque pile de préformes, formant de ce fait une "enveloppe" de renforcement de transfert de chaleur pour augmenter l'efficacité du cycle CVI/CVD.

4. Appareil selon la revendication 2, dans lequel ledit élément de distribution de chaleur passif central est un tube de graphite à extrémités couvertes de 12,5 cm à 20,5 cm (5 à 8 pouces) de diamètre, ou est une tige cylindrique de 2,5 cm à 12,5 cm (1 à 5 pouces) de diamètre.

5. Appareil selon la revendication 2, dans lequel ledit élément de distribution de chaleur passif central est un tube composite de carbone - carbone à extrémités couvertes de 12,5 cm à 20,5 cm (5 à 8 pouces) de diamètre.

6. Appareil selon la revendication 2, dans lequel le fond et le sommet dudit moufle de four sont plans, et ladite paroi extérieure et ledit élément de distribution de chaleur passif central sont de forme cylindrique, et dans lequel lesdites parois inférieure, supérieure et extérieure comprennent du graphite ou une matière composite de carbone - carbone.
